# EUROPEAN PATENT APPLICATION

(11) **EP 4 401 117 A1**
(43) Date of publication of application: **17.07.2024**
(21) Application number: 23220431.3
(22) Date of filing: 28.12.2023
(51) Int. Cl.: H01L 21/67

(54) **TEMPERATURE CONTROL METHOD, METHOD OF MANUFACTURING SEMICONDUCTOR DEVICE, TEMPERATURE CONTROL SYSTEM, SUBSTRATE PROCESSING APPARATUS, AND PROGRAM**

(30) Priority: 16.01.2023 JP 2023004719
(71) Applicant: Kokusai Electric Corp., Tokyo 1010045 (JP)
(72) Inventor: NAKANISHI, Kento, Toyama-shi, Toyama, 9392393 (JP); YAMAGUCHI, Hideto, Toyama-shi, Toyama, 9392393 (JP); SHIGEMATSU, Seiya, Toyama-shi, Toyama, 9392393 (JP)
(74) Representative: Bardehle Pagenberg Partnerschaft mbB Patentanwälte Rechtsanwälte

(57) **Abstract**

According to one embodiment of the present disclosure, there is provided a technique of controlling a temperature of a substrate by using a moving average value calculated by performing a moving average process on temperature values detected by a temperature sensor installed to be rotatable together with a holder configured to hold the substrate.

## Description

### CROSS-REFERENCE TO RELATED APPLICATION

This application is based upon and claims the benefit of priority from Japanese Patent Application No. 2023-004719, filed on January 16, 2023, the entire contents of which are incorporated herein by reference.

### TECHNICAL FIELD

The present disclosure relates to a temperature control method, a method of manufacturing a semiconductor device, a temperature control system, a substrate processing apparatus, and a program.

### BACKGROUND

In the related art, as a process of manufacturing a semiconductor device, a predetermined process is performed on a wafer (hereinafter also referred to as a substrate).

In the related art, there is known a technique for controlling a temperature of a process chamber by using a temperature detected by a temperature sensor that moves together with a boat (hereinafter also referred to as a holder). However, if the temperature of the process chamber during a substrate processing process is controlled by using the temperature detected by the temperature sensor, temperature fluctuations within the processing space may be detected, which may affect controlling of a process chamber.

### SUMMARY

Some embodiments of the present disclosure provide a technique capable of suppressing the influence of temperature fluctuations in a processing space on temperature control.

According to one embodiment of the present disclosure, there is provided a technique of controlling a temperature of a substrate by using a moving average value calculated by performing a moving average process on temperature values detected by a temperature sensor installed to be rotatable together with a holder configured to hold the substrate.

### BRIEF DESCRIPTION OF DRAWINGS

The accompanying drawings, which are incorporated in and constitute a part of the specification, illustrate embodiments of the present disclosure.
FIG. 1 is a front sectional view of a substrate processing apparatus according to an embodiment of the present disclosure.
FIG. 2 is a schematic diagram of the substrate processing apparatus according to an embodiment of the present disclosure.
FIG. 3A is a top view showing a state of the substrate processing apparatus according to an embodiment of the present disclosure when a substrate is accommodated. FIG. 3B is a top view showing a state of the substrate processing apparatus according to an embodiment of the present disclosure when the substrate is accommodated. FIG. 3C is a side view showing a state of the substrate processing apparatus according to an embodiment of the present disclosure when the substrate is accommodated.
FIG. 4 is a diagram showing a hardware configuration of a controller in the substrate processing apparatus according to an embodiment of the present disclosure.
FIG. 5 is a diagram showing a hardware configuration of a temperature controller in the substrate processing apparatus according to an embodiment of the present disclosure.
FIG. 6 is a control block diagram of a temperature controller in the substrate processing apparatus according to an embodiment of the present disclosure.
FIG. 7 is a diagram for explaining a temperature control performed in the substrate processing apparatus according to an embodiment of the present disclosure.
FIG. 8 is a diagram illustrating an example of a moving average table in the substrate processing apparatus according to an embodiment of the present disclosure.
FIG. 9 is a flowchart showing a temperature control sequence performed in the substrate processing apparatus according to an embodiment of the present disclosure.
FIG. 10A is a diagram for explaining a substrate processing sequence performed in the substrate processing apparatus according to an embodiment of the present disclosure. FIG. 10B is a diagram for explaining a substrate processing sequence performed in the substrate processing apparatus according to the embodiment of the present disclosure and is a graph showing temperatures in the respective steps of the substrate processing sequence.
FIG. 11 is a graph showing a change in a moving average value of temperature values detected by a boat TC in the substrate processing apparatus according to an embodiment of the present disclosure.
FIG. 12 is a graph showing changes in the temperature value detected by the boat TC and a heater output when temperature control is performed by using the moving average value of the temperature values detected by the boat TC in the substrate processing apparatus according to an embodiment of the present disclosure.
FIG. 13 is a diagram illustrating an example of a plurality of moving average tables in the substrate processing apparatus according to an embodiment of the present disclosure.
FIG. 14 is a diagram illustrating an example of a plurality of temperature control tables in the substrate processing apparatus according to an embodiment of the present disclosure.
FIG. 15 is a diagram showing an example of a temperature control table for each temperature zone in the substrate processing apparatus according to an embodiment of the present disclosure.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components have not been described in detail so as not to unnecessarily obscure aspects of the various embodiments.

An embodiment of the present disclosure will be described below with reference to the drawings. It should be noted that the drawings used in the following description are all schematic, and the dimensional relationship of the respective elements, the ratio of the respective elements, and the like shown in the drawings do not necessarily match the real ones. Further, the dimensional relationship of the respective elements, the ratio of the respective elements, and the like do not necessarily match between a plurality of drawings. In addition, elements having substantially the same configurations are designated by like reference numerals in a plurality of drawings. Each element will be described in connection with the drawing in which it first appears, and the description will be omitted in connection with subsequent drawings unless it is particularly necessary.

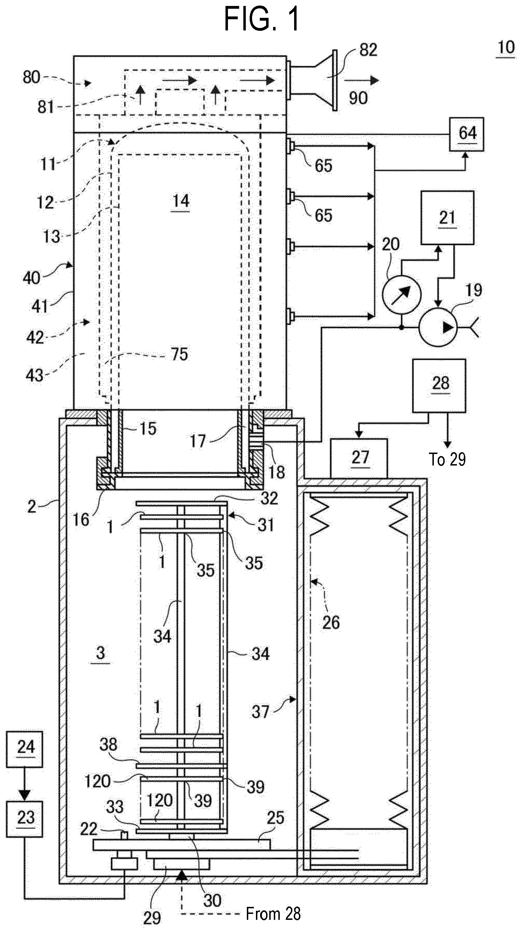

As shown in FIG. 1, the substrate processing apparatus 10 includes a process tube 11 as a supported vertical reaction tube. The process tube 11 is composed of an outer tube 12 and an inner tube 13 arranged concentrically with each other. The outer tube 12 is made of quartz (SiO₂) and is integrally formed into a cylindrical shape with a closed upper end and an open lower end. The inner tube 13 is formed into a cylindrical shape with both upper and lower ends opened. The tubular hollow portion of the inner tube 13 forms a process chamber 14 into which a boat 31 as a holder is loaded, and the lower end side (opening space) of the inner tube 13 constitutes a furnace opening (furnace opening space) 15 through which the boat 31 loaded and unloaded. As will be described later, the boat 31 is configured to hold a plurality of substrates (hereinafter also referred to as wafers) 1 arranged in a long line. Therefore, an inner diameter of the inner tube 13 is set to be larger than a maximum outer diameter (e.g., 300 mm in diameter) of the substrate 1 to be handled.

The lower end portion between the outer tube 12 and the inner tube 13 is hermetically sealed by a manifold 16, which serves as a furnace opening flange portion formed in a substantially cylindrical shape. For replacing the outer tube 12 and the inner tube 13 or etc., the manifold 16 is detachably attached to the outer tube 12 and the inner tube 13, respectively. Since the manifold 16 is supported by the housing 2 of the substrate processing apparatus 10, the process tube 11 is installed vertically. Hereinafter, the inner tube 13 may be omitted as the process tube 11 in the drawings.

Due to a gap between the outer tube 12 and the inner tube 13, a horizontal cross section of an exhaust passage 17 is formed in a circular ring shape with a constant width. As shown in FIG. 1, one end of an exhaust pipe 18 is connected to an upper portion of a side wall of the manifold 16, and the exhaust pipe 18 is arranged to communicate with a lowermost end portion of the exhaust passage 17. An exhaust device 19 controlled by a pressure controller 21 is connected to the other end of the exhaust pipe 18, and a pressure sensor 20 is connected to the middle of the exhaust pipe 18. The pressure controller 21 is configured to feedback-control the exhaust device 19 based on measurement results from the pressure sensor 20.

A seal cap 25 serving as a lid for closing a lower end opening of the manifold 16 is in contact with the manifold 16 from the lower side of the manifold 16 in the vertical direction. The lid 25 is formed in a disc shape to have a diameter approximately equal to the outer diameter of the manifold 16. The lid 25 is configured to be vertically raised and lowered by a boat elevator 26 which is protected by a boat cover 37 installed in the transfer chamber 3 of the housing 2. The boat elevator 26 includes a motor-driven feed screw shaft device, a bellows, and the like. The motor 27 of the boat elevator 26 is configured to be controlled by a drive controller 28. A rotary shaft 30 is disposed on the center line of the lid 25 and is rotatably supported. The rotary shaft 30 is configured to be rotationally driven by a motor 29 controlled by a drive controller 28. A boat 31 is vertically supported at an upper end of the rotary shaft 30. In this embodiment, the rotary shaft 30 and the motor 29 constitute a rotation mechanism.

A gas introduction pipe 22 is disposed below the manifold 16 (in the lid 25 in the embodiment) so as to communicate with the furnace opening 15 of the inner tube 13. A raw material gas supply device, a reaction gas supply device, and an inert gas supply device (hereinafter referred to as gas supply devices) 23 are connected to the gas introduction pipe 22. The gas supply devices 23 are configured to be controlled by a gas flow rate controller 24. The gas introduced into the furnace opening 15 from the gas introduction pipe 22 flows through the process chamber 14 of the inner tube 13, passes through the exhaust passage 17, and then, is exhausted through the exhaust pipe 18.

The boat 31 includes a pair of upper and lower end plates 32 and 33, and three pillars 34 as holding members installed vertically between the end plates 32 and 33. Multiple holding grooves 35 are cut on the three pillars 34 at equal intervals in the longitudinal direction. The holding grooves 35 cut at the same stage in the three pillars 34 are opened to face each other. The boat 31 holds a plurality of substrates 1 horizontally with their centers aligned with each other by inserting the substrates 1 between the holding grooves 35 of the three pillars 34 at the same stages. Furthermore, by inserting the heat insulating plates 120 between the holding grooves 39 of the three pillars 34 at the same stages, the heat insulating plates 120 are held horizontally with their centers aligned with each other.

In other words, the boat 31 is configured to distinguish a substrate processing region between the end plates 32 and 38 where the plurality of substrates 1 are held, and a heat insulating plate region between the end plates 38 and 33 where the plurality of heat insulating plates 120 are held. The heat insulating plate region is arranged below the substrate processing region. The heat insulating part 36 is constituted by the heat insulating plates 120 held between the end plates 38 and 33.

The rotary shaft 30 is configured to support the boat 31 in a state in which it is lifted from a top surface of the lid 25. The heat insulating part 36 is provided at the furnace opening 15 and is configured to insulate the furnace opening 15. Further, the motor 29 for rotating the boat 31is arranged under the lid 25. The motor 29 includes a hollow motor structure, and the rotary shaft 30 passes through the motor 29.

On the outside of the process tube 11, a heater 40 serving as a heating part is arranged concentrically and supported by the housing 2. Heater thermocouples 65 as first temperature sensors are installed in a vicinity of the heater 40. A temperature controller 64 is configured to feedback-control the heater 40 based on measurement results from the first temperature sensor 65. Thus, the heater 40 is configured to heat the substrate 1 held in the boat 31 within the substrate processing region. Details of the first temperature sensor 65 will be described later. Further, the heater 40 includes a case 41. The case 41 is made of stainless steel (SUS) and has a tubular shape, preferably a cylindrical shape, with a closed upper end and an open lower end. An inner diameter and overall length of the case 41 are set to be larger than an outer diameter and overall length of the outer tube 12.

A heat insulating structure 42 is installed inside the case 41. The heat insulating structure 42 includes a side wall outer layer (hereinafter also referred to as an outer layer) disposed on the outer side and a side wall inner layer (hereinafter also referred to as an inner layer) disposed on the inner side. The heat insulating structure 42 is preferably formed in a tubular shape, preferably a cylindrical shape. A side wall portion 43 of the cylindrical body is formed into a multi-layer structure.

A cooling air 90 is allowed to flow through a gas supply path provided in the inner layer and is supplied to a space 75 via a supply path including the gas supply path 108.

As shown in FIG. 1, a ceiling wall portion 80 serving as a ceiling portion is placed over the upper end side of the side wall portion 43 of the heat insulating structure 42 so as to close the space 75. An exhaust hole 81 is formed in the ceiling wall portion 80 in an annular shape as a portion of an exhaust path for exhausting the atmosphere of the space 75. The lower end as an upstream end of the exhaust hole 81 communicates with the inner space 75. A downstream end of the exhaust hole 81 is connected to an exhaust duct 82. The cooling air 90 blown into the space 75 is exhausted through the exhaust hole 81 and the exhaust duct 82.

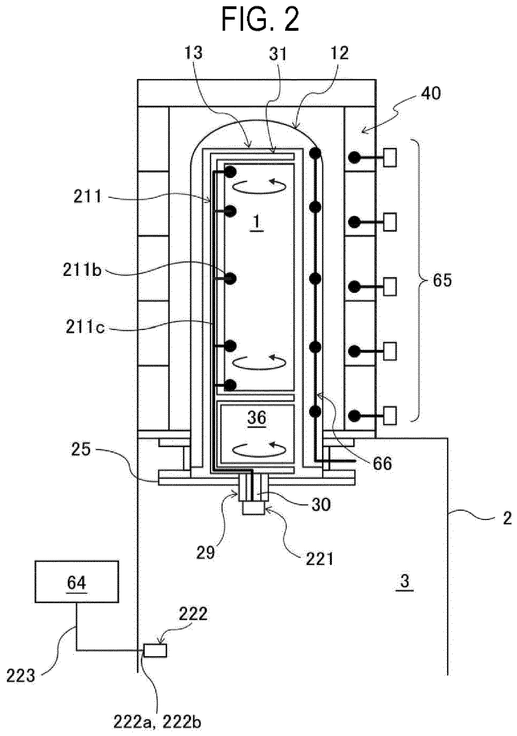

As shown in FIG. 2 (in FIG. 2, the processed substrate is indicated as "1" and the illustration thereof is omitted), the heater 40 can be divided into a plurality of zones (five zones in FIG. 2) in the vertical direction. Since the heater 40 is provided for each zone, multiple heaters are stacked one above another. The heater thermocouples 65 (first temperature sensors) are installed in the respective zones to measure the temperatures of the heaters.

In-furnace thermocouple (third temperature sensor) 66 is installed inside the outer tube 12 to measure the temperature inside the outer tube. This in-furnace thermocouple 66 includes a structure in which a number of thermocouples corresponding to the number of zones are accommodated in one quartz tube. The temperature measuring points are provided at the positions facing the zones.

A substrate thermocouple (second temperature sensor) 211 for measuring the temperature of the substrate is configured to rotate together with the substrate 1 when the substrate 1 rotates by a rotation of the boat 31. The substrate thermocouple 211 includes a temperature measurement portion 211b that measure the temperature of the substrate, and a cable 211c including a wire that constitutes the temperature measurement portion 211b. The temperature of the substrate will be described later.

The substrate thermocouple 211 is an example of a "temperature sensor installed to be rotate together with a holder" in the technique of the present disclosure. The temperature sensor may be any sensor as long as it can measure a temperature as an electrical signal. The temperature sensor is not limited to the thermocouple, but may be other sensors such as a temperature measuring resistor and the like.

Furthermore, the heater thermocouple 65 and the in-furnace thermocouple 66 may not be thermocouple, but may be replaced by other sensors such as a temperature measuring resistor and the like, as long as they can measure the temperature as an electrical signal.

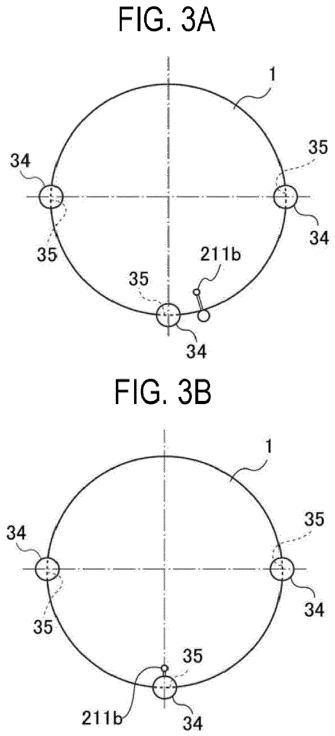

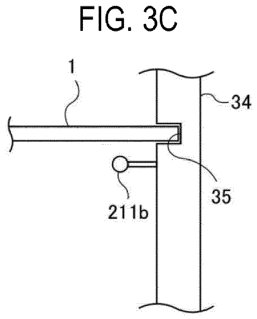

As shown in FIGS. 3A to 3C, the temperature measurement portion 211b of the substrate thermocouple 211 serving as the second temperature sensor is arranged at the peripheral portion of the substrate 1 (on the inner side of the peripheral end). Further, in FIG. 3A, the temperature measurement portion 211b of the substrate thermocouple 211 is arranged in a vicinity of the pillar 34. As used herein, the expression "in a vicinity of the pillar 34" means that the temperature measurement portion 211b is arranged at a position closer to the pillar 34 than an intermediate position between the pillar 34 and the center of the substrate 1 in a state in which the substrate 1 are held by the pillar 34. As shown in FIG. 3B, the substrate thermocouple 211 may be included in the pillar 34. In this way, according to FIGS. 3A and 3B, the substrate thermocouple 211 (temperature measurement portion 211b) is arranged in the space where the substrate 1 are processed. Therefore, the substrate thermocouple 211 can measure the temperature in a space closer to the substrate 1 than the first temperature sensor 65 or the third temperature sensor, which makes it possible to measure the temperature of the substrate 1 more accurately. Although omitted here to clarify the arrangement of the temperature measurement portion 211b, a protection tube is installed to isolate the temperature measurement portion 211b from the processing space. The protection tube is made of, for example, quartz.

Returning to FIG. 2, the rotary shaft 30 includes a hole through which the cable 211c passes. The rotary shaft 30 includes a structure in which the cable 211c leads to a transmitter 221 outside the process chamber 14 (for example, below the rotary shaft 30) while performing vacuum sealing using a hermetic seal or the like. The cable 211c is connected to the transmitter 221 disposed under the seal cap 25.

The transmitter 221 is fixed to the rotary shaft 30 and configured to move together with the rotary shaft 30. The transmitter 221 converts an electric signal (voltage) from the substrate thermocouple 211 to a digital signal, which is inputted via the cable 211c, and wirelessly transmits the digital signal via radio waves.

A receiver 222 is fixedly installed in the area under the lid 25. The receiver 222 includes a terminal (output terminal) 222a that receives the digital signal outputted from the transmitter 221 and outputs the received digital signal through serial communication, or a terminal (output terminal) 222b that converts the received digital signal into an analog signal and outputs the converted analog signal. A cable 223 connects the output signal terminal for the digital signal or the analog signal to a temperature indicator (not shown) or a temperature controller 64, and temperature data is input to the temperature controller 64.

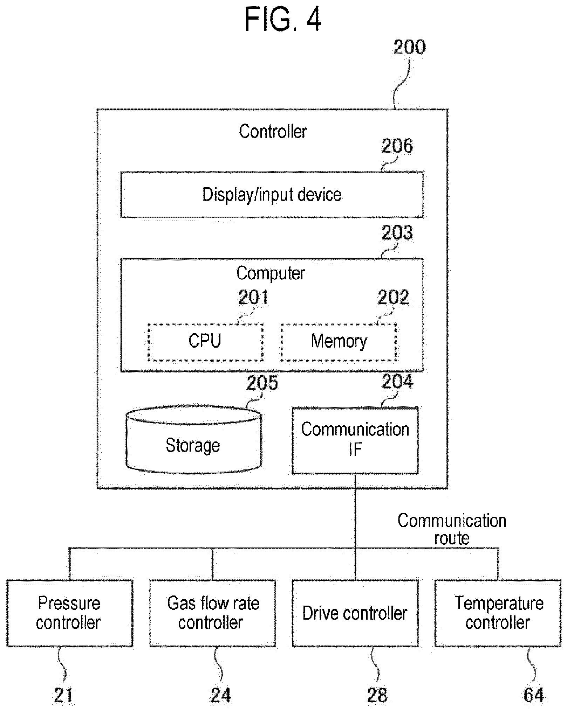

As shown in FIG. 4, the controller 200, which is a control computer as a control part, includes a computer 203 including a CPU (Central Processing Unit) 201, a memory 202, and the like, a communication IF (Interface) 204 as a communication part, a memory device 205 as a memory part, and a display/input device 206 as an operation part. In other words, the controller 200 includes components of a general computer.

The CPU 201 constitutes a core of the operation part, executes a control program stored in the memory device 205, and executes a recipe (e.g., process recipe) recorded in the memory device 205 according to an instruction from the display/input device 206. Furthermore, the memory 202 as a temporary memory part functions as a work area for the CPU 201.

The communication part 204 is electrically connected to the pressure controller 21, the gas flow rate controller 24, the drive controller 28, and the temperature controller 64 (these may also be collectively referred to as sub-controllers). The controller 200 can exchange data regarding an operation of each component with the sub-controllers via the communication part 204.

The memory 205 includes, for example, a flash memory, a hard disk drive (HDD), or the like. A control program configured to control operations of the substrate processing apparatus 10, a process recipe in which sequences, conditions, and the like of substrate processing as described below are specified is readably stored in the memory 205. Further, the process recipe functions as a program configured to cause the controller 200 to execute each sequence in the substrate processing described below, to obtain a predetermined result. Hereinafter, the process recipe and the control program will be generally and simply referred to as a "program." Further, when the term "program" is used herein, it may indicate a case of including only the process recipe, a case of including only the control program, or a case of including both the process recipe and the control program.

The controller 200 may be configured by installing, in a computer, the above-mentioned program recorded and stored in an external memory device (e.g., a magnetic disk such as a hard disk or the like, an optical disk such as a CD (Compact Disk) or the like, a magneto-optical disk such as an MO (Magnetic Optical Disk) or the like, or a semiconductor memory such as a USB (Universal Serial Bus) memory or the like. The memory device 205 and the external memory device are configured as computer-readable recording medium. Hereinafter, these are collectively referred to simply as a recording medium. When the term "recording medium" is used in this specification, it may include only the memory device 205, only the external memory device, or both. The program may be provided to the computer using communication means such as the Internet or a dedicated line, without using an external memory device.

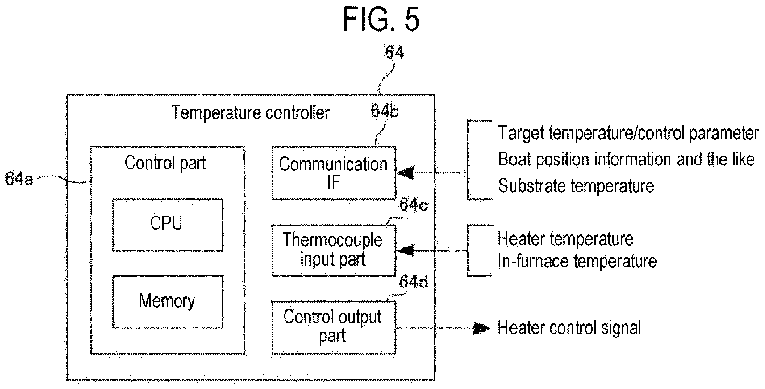

As shown in FIG. 5, the temperature controller 64 includes a control part 64a, a communication interface (IF) 64b, a thermocouple input part 64c, and a control output part 64d.

The control part 64a includes a hardware configuration as a general computer including a CPU, a memory, and the like. The control part 64a executes a control program to perform control calculations according to a below-described temperature control algorithm by using information acquired by the communication IF 64b and the thermocouple input part 64c, and outputs calculation results to the control output part 64d.

The communication IF 64b includes a wired IF to be connected to the controller 200, which is a host controller, and a receiver 222 as a wireless IF to be connected to the transmitter 221 fixed to the boat 31.

The communication IF 64b receives information such as a target temperature and a control parameter from the controller 200, and transmits a control calculation result and temperature information. The communication IF 64b also receives boat position information from the drive controller 28 of the boat elevator 26. Furthermore, the communication IF 64b receives temperature of the substrate thermocouple 211 via the transmitter 221 and the receiver 222.

The thermocouple input part 64c receives electrical signals corresponding to temperatures from the heater thermocouple 65 and the in-furnace thermocouple 66, converts the electrical signals into digital signals, and outputs the digital signals to the control part 64a.

The control output part 64d outputs a heater control signal for controlling a temperature of the heater 40 based on the calculation result received from the control part 64a.

In the following description, the heater thermocouple 65 will be referred to as a heater TC. Further, the substrate thermocouple 211 will be referred to as a boat TC. Further, the in-furnace thermocouple 66 will be referred to as an in-furnace TC.

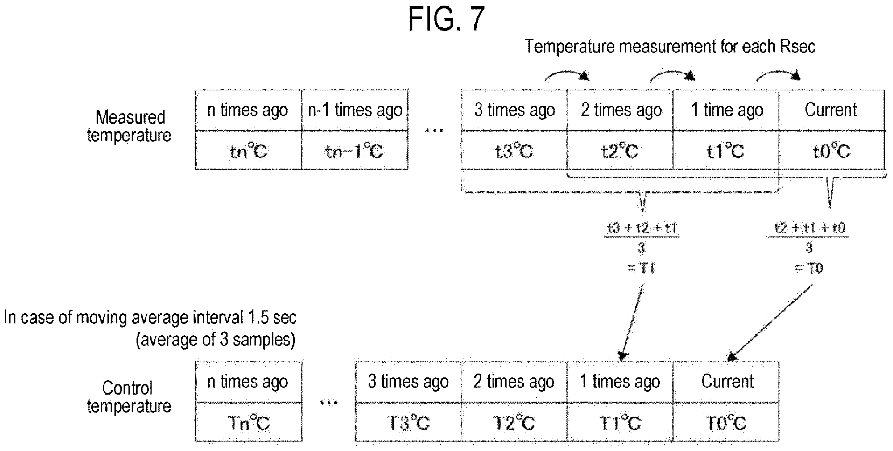

Next, an example of a control block diagram of the temperature controller 64 in an embodiment will be described with reference to FIG. 7.

"Target temperature" in FIG. 7 refers to a target temperature corresponding to a control target zone among the plurality of divided zones of the heater 40, among target temperatures obtained from the controller 200 via the communication IF 64b included in the temperature controller 64. The "target temperature" is inputted to a plus side input terminal of a first subtractor.

"Boat TC detected temperature" indicates a temperature (temperature in a vicinity of the substrate) measured by the substrate thermocouple 211 corresponding to the control target zone. The "boat TC detected temperature" will be hereinafter referred to as a substrate temperature. The substrate temperature is inputted to the moving average processor, and then the output of the moving average processor is inputted to a minus side input terminal of the first subtractor. Thereby, the substrate temperature measured by the substrate thermocouple 211 is controlled to the corresponding target temperature.

A number of discretized samples and/or a moving average time, as information of a moving average interval, are set as parameters in advance, and the moving average processor executes a process of outputting an average value of input data according to the parameters.

FIG. 7 shows an example of calculation in the moving average processor. In the example shown in FIG. 7, the moving average interval as a setting parameter is set to 3R seconds. For example, the temperature data is discretized every R seconds, and therefore corresponds to three samples. "Measured temperature" indicates the inputted "substrate temperature", and "control temperature" indicates the output of the "moving average processor".

As shown in FIG. 7, for example, T0 °C, which is the "current" value of "control temperature", is an average value of the values stored in "Current", "1 time ago", and "2 times ago" of the "measured temperature". Every time the value of the "control temperature" is updated (i.e., every time R seconds have elapsed in this case), the "measured temperature" is calculated and outputted. On the other hand, for "measured temperature", the current measured temperature is first stored in "Current". Every R seconds, the storage location is moved as the time elapses from "Current" to "1 time ago", from "1 time ago" to "2 times ago", from "2 times ago" to "3times ago".

The "moving average interval" set as a moving average parameter is preferably adjusted such that a time for one rotation of the boat 31 is set as a base value, in accordance with a rotational speed of the boat 31. The moving average processor is configured to be able to arbitrarily set the "moving average interval." Just like the "target temperature", the "moving average interval" is recorded in the controller 200 as a recipe or a table accompanied with the recipe. The temperature controller 64 is configured to be able to obtain information on the "moving average interval" from the controller 200 via the communication IF 64b included in the temperature controller 64.

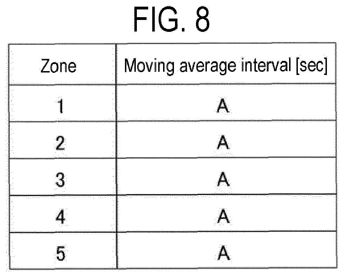

FIG. 8 shows an example of a table of moving average intervals recorded in the controller 200 when the heater 40 is divided into five zones. As shown in FIG. 8, for example, in the moving average interval table, information on the moving average intervals is managed for each zone.

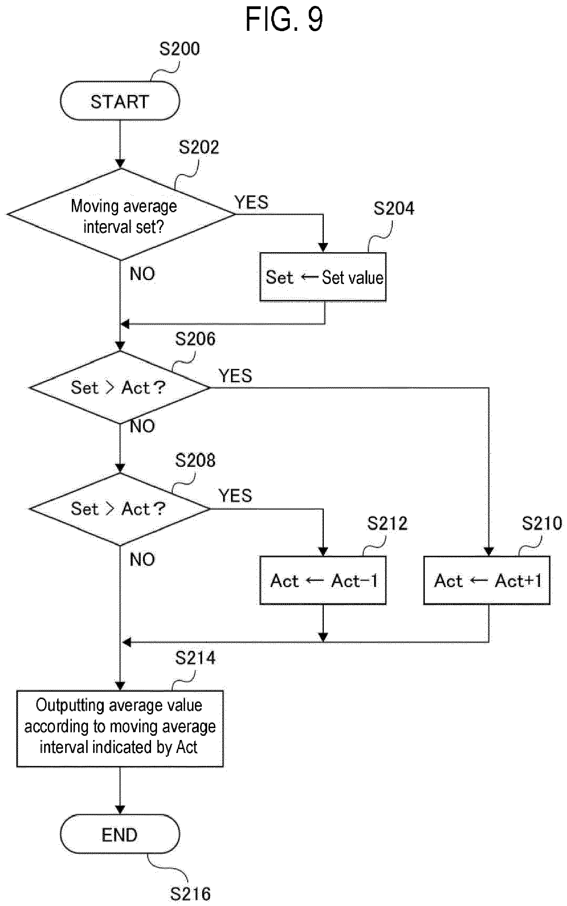

Next, an example of the operation of the moving average processor will be described. A flowchart showing an example of the operation of the moving average processor is shown in FIG. 9.

Step S200 indicates a starting position when the control part 64a starts a process. The process is typically started repeatedly at regular time intervals.

Step S202 determines whether a moving average interval has been set from the end of the previous series of processes to the present, and is branched out.

Step S204 is a process that is executed when step S202 is affirmative, to write information of the moving average interval in a register Set. The register Set stores information of the moving average interval inputted and set from the controller 200. For example, the register Set indicates the number of samples corresponding to the set moving average interval.

In steps S206 and S208, the register Set and a register Act are compared and determined to branch the process. In step S206, the magnitude of Set>Act is determined, and in step S208, the magnitude of Set<Act is determined. By combining these steps, the process is branched to step S210 if Set>Act, to step S212 if Set<Act, and to step S214 if Set=Act. The register Act stores information of a moving average interval currently being processed. For example, the register Act indicates the number of samples corresponding to the moving average interval currently being processed.

Step S210 increments the register Act by one. Step S212 decrements the register Act by one. Step S214 calculates and outputs the average value of the input data according to the moving average interval information indicated by the register Act. This process includes the process of moving the storage location of the measured temperature data, as described with reference to FIG. 7. Step S216 indicates the end position of the process.

By performing the processes according to these steps, when there is a difference between the values of the register Set and the register Act, step S206 and step S210 are performed if Set>Act. Step S206, step S208 and step S212 are performed if Set<Act. As a series of the steps is repeated, Act approaches Set gradually as time elapses and eventually matches Set. Unless there is a new change in Set, the average value is outputted in accordance with the value of Act that matches Set, in a processing order of step S202, step S206, step S208, and step S214.

Furthermore, even if a new moving average interval is set and steps S202 and S204 are performed in order so that a new change is made in Set, calculations will not be performed immediately in accordance with the new moving average interval setting, but an average value is outputted in accordance with the value of Act that gradually approaches Set.

By performing such processes, even if there is a change in the setting of the moving average interval, the setting is reflected gradually. Therefore, it is possible to ensure that jumps (i.e., changes without continuity in a short period of time) do not occur in the output of the moving average processor.

The jumps in the output of the moving average processor caused by immediately reflecting the changed moving average interval in the average value calculation may cause temperature control to become unstable. It is therefore possible to prevent the temperature control from becoming unstable.

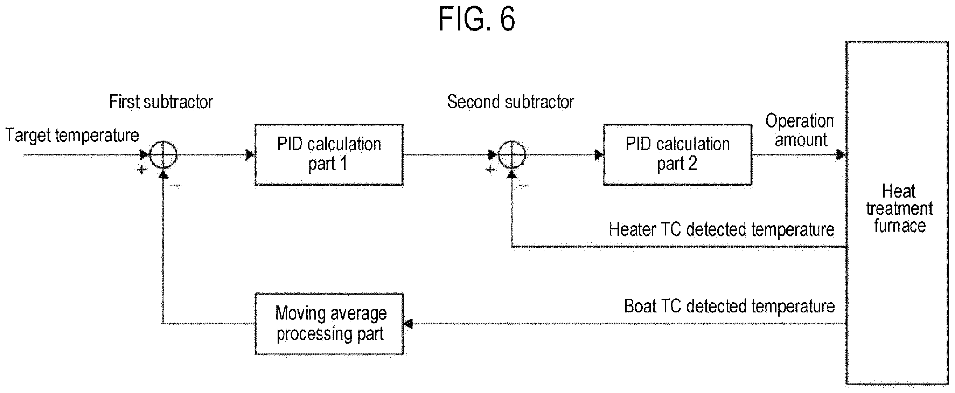

Returning to FIG. 6, the first subtractor calculates a deviation between the target temperature and the output of the moving average processor and then outputs the deviation to a PID calculation part 1.

The PID calculation part 1 receives the deviation from the first subtractor and performs a known PID calculation. The PID calculation result is inputted to the plus side input terminal of a second subtractor.

"Heater TC detected temperature" indicates a heater temperature measured by the heater thermocouple 65 corresponding to a zone to be controlled. The heater temperature is inputted to the minus side input terminal of the second subtractor.

The second subtractor calculates a deviation between the calculation result of the PID calculation part 1 and the temperature of the heater and then outputs the deviation to a PID calculation part 2.

The PID calculation part 2 receives the deviation from the second subtractor and performs a known PID calculation. The PID parameters used in the PID calculation part 2 are different from those used in the PID calculation part 1. The PID calculation result is outputted as an "adjustment amount".

It is desirable that the PID parameters used when performing PID calculation in the PID calculation part 1 and the PID calculation part 2 are adjustable. The PID parameters are examples of "heating part control parameters" in the technique of the present disclosure. The PID calculation part 1 and the PID calculation part 2 are configured so that PID parameters can be set arbitrarily. Just like the "target temperature," the PID parameters are recorded in the controller 200 as a recipe or a table accompanied with the recipe. The temperature controller 64 is configured to be able to obtain PID parameter information from the controller 200 via the communication IF 64b included in the temperature controller 64.

The "adjustment amount" indicates a value outputted to the control output part 64d (see FIG. 5) as a control calculation result corresponding to the zone to be controlled. This value is converted into a signal for heating a zone of the heater 40 to be controlled and is outputted, via the control output part 64d (see FIG. 5).

As described above, the temperature controller 64 of this embodiment executes control calculations according to a control algorithm referred to as so-called cascade control, so that the substrate temperature measured by the substrate thermocouple 211 matches the corresponding target temperature.

Further, since the output of the moving average processor is inputted to the minus side input terminal of the first subtractor, even if a temperature distribution exists in the horizontal cross section of the heater 40 and even if the boat TC detects temperature fluctuations occurring in the circumferential direction, the moving average processor suppresses the temperature fluctuations and outputs an electric signal while suppressing the temperature fluctuations. Therefore, the heater output does not become unstable, and the temperature controller 64 can stably control the heater output.

The operation of the moving average processor is not limited to the above-described one, and may be changed in various ways, such as being controlled by other advanced control algorithms.

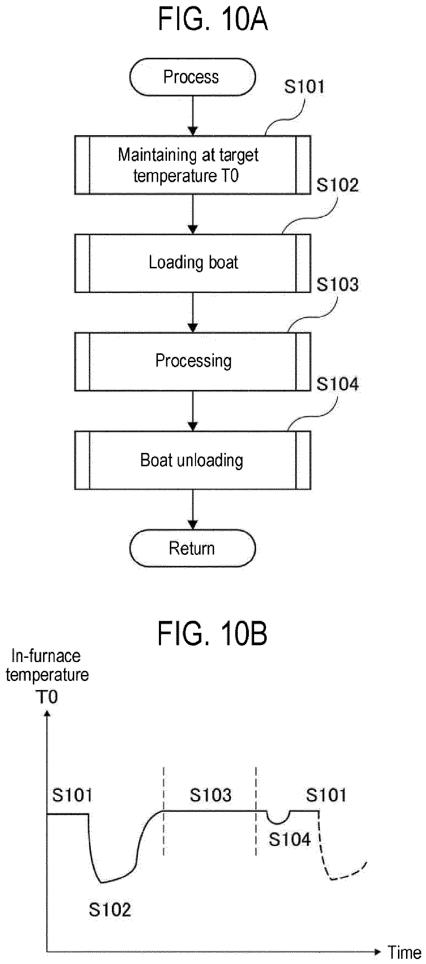

Next, an example of a substrate processing sequence performed in the substrate processing apparatus will be described with reference to FIGS. 10A and 10B. FIG. 10A is a flowchart showing a substrate processing sequence. FIG. 10B is a graph showing the furnace temperature in the respective steps S101 to S104 of the substrate processing sequence.

Step S101 (standby step) is a process in which the temperature inside the furnace (process chamber 14) is stabilized at a standby temperature T0. In step S101, the substrate 1 is not loaded into the furnace as yet.

Step S102 (boat loading step) is a process of loading the substrate 1 held on the boat 31 into the furnace. The temperature of the boat 31 and the substrate 1 is lower than the furnace temperature T0 at this point, and the atmosphere outside the furnace (room temperature atmosphere) is introduced into the furnace as a result of loading the substrate 1 into the furnace. Therefore, the temperature in the furnace temporarily becomes lower than T0. Thereafter, the temperature in the furnace is stabilized at T0 again after a certain period of time under the control of the temperature controller 64. In this figure, the target temperature after the substrate is loaded into the furnace and the target temperature at the next step S103 are shown to be the same as in step S101. However, the target temperature after loading may vary depending on the required conditions in step S103.

Step S103 (processing step) is a process in which the temperature in the furnace is maintained and stabilized at the target temperature T0 in order to perform a predetermined process on the substrate 1.

Step S104 (boat unloading step) is a process in which the processed substrate 1 is unloaded from the furnace together with the boat 31.

If unprocessed substrate 1 still remain, the processed substrate 1 is evacuated from the boat 31 and replaced with the unprocessed substrate 1, and the series of steps S101 to S104 is repeated.

These steps are executed after achieving a stable state in which the temperature in the furnace is within a predetermined small temperature range with respect to the target temperature and this temperature is maintained for a predetermined period of time.

### <Effects>

According to this embodiment, one or more of the following effects may be obtained.

As described above, the substrate processing apparatus 10 of the embodiment of the present disclosure controls the temperature of the substrate 1 using the moving average value which is calculated by performing the moving average process on the temperature values detected by the temperature sensor such as the substrate thermocouple 211 provided on the boat 31 holding the substrate 1 so as to be rotatable together with the boat 31.

Since a temperature distribution exists in the horizontal cross section of the heater 40, and the boat TC detects temperature fluctuations occurring in the circumferential direction, temperature fluctuations occur in the temperature detected by the boat TC.

When the temperature of the substrate 1 is controlled without using the moving average value, the temperature may not be controlled properly due to temperature fluctuations. That is, in the conventional control, temperature control is performed using the detected temperature as the control temperature. Therefore, if the temperature detected by the boat TC becomes unstable due to temperature fluctuations, the heater output may also become unstable.

On the other hand, in the substrate processing apparatus 10 according to the embodiment, the temperature of the substrate 1 is controlled using the moving average value. Therefore, it is possible to stabilize the heater output.

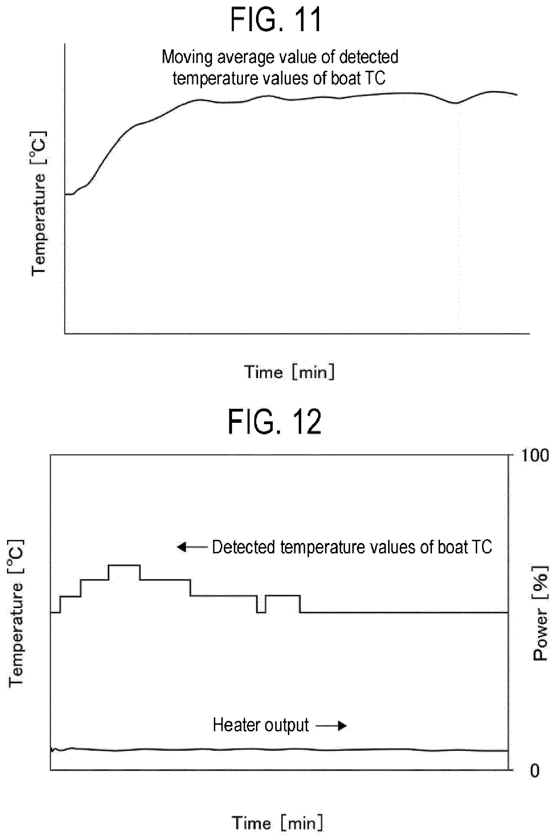

FIG. 11 is a graph showing changes in the moving average value of temperature values detected by the boat TC. The horizontal axis in the graph indicates the time [min], and the vertical axis indicates the temperature [degrees C]. As shown in FIG. 11, the moving average value of the temperature values detected by the boat TC has smooth characteristics with suppressed vibrations.

FIG. 12 is a graph showing changes in the temperature value detected by the boat TC and the heater output when temperature control is performed using the moving average value of the temperature values detected by the boat TC. The horizontal axis in the graph indicates the time [min], and the vertical axis indicates the temperature [degrees C] and the heater output [%]. The heater output [%] indicates the ratio of the current heater output to the maximum output of the heater. As shown in FIG. 12, it can be seen that the heater output is stabilized by controlling the temperature using the moving average value.

The substrate processing apparatus 10 according to an embodiment may be configured to be able to execute a process recipe including a plurality of steps, and the moving average value may be determined by a moving average parameter for each step.

In the above embodiment, the same effects as in the above-described embodiment may be obtained. Furthermore, in this embodiment, the moving average value can be arbitrarily set for each step of the process recipe. Therefore, it is possible to achieve high-precision temperature control by combining a case in which the moving average value of the detected temperature values is used and the case in which the detected temperature values are used as they are.

Furthermore, in the substrate processing apparatus 10, the higher the control temperature range and the lower the rotation speed, the larger the vibration amplitude of the temperature value detected by the boat TC tends to be.

Therefore, the moving average parameter may be capable of being set according to a rotational speed of the boat 31 that is arbitrarily set for each step, or the moving average parameter may be capable of being set according to rotational speed information including the rotational speed of the boat 31 that is obtained in advance.

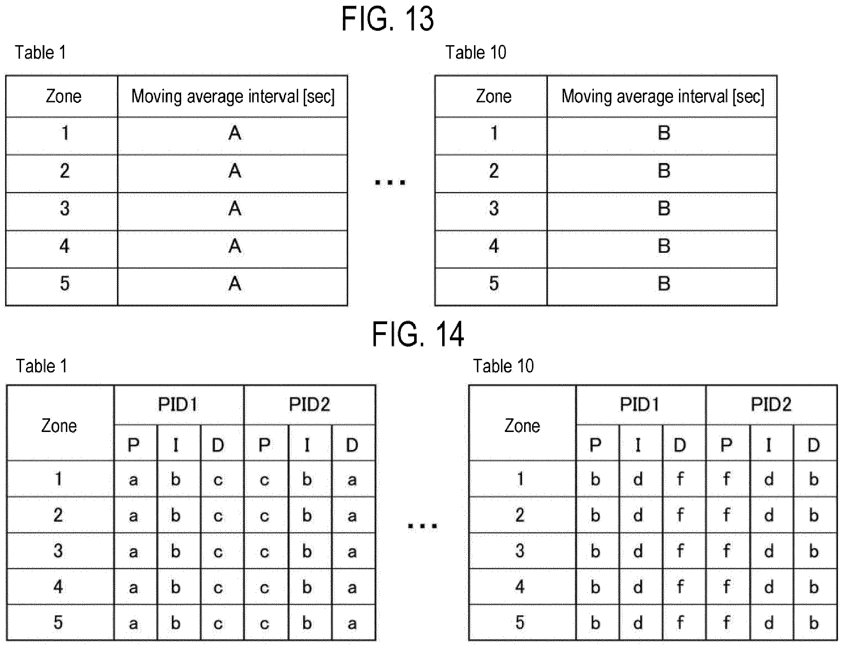

When setting the moving average parameter according to the rotational speed or the rotational speed information, for example, as shown in FIG. 13, a plurality of tables in which different moving average parameters are set for each rotational speed or rotational speed information may be prepared. And the table to be referenced may be switched depending on the rotational speed or the rotational speed information. In a normal process, the rotation speed is 0.5 rpm or more and 3.0 rpm or less. Therefore, the moving average parameter is preferably 20 or more and 120 or less. If the rotational speed is too high, there is a risk that the substrate 1 may become misaligned. Actually, the rotational speed is limited to 3.0 rpm. If the rotational speed becomes less than 0.5 rpm, there is a possibility that the processing gas and the like supplied to the substrate 1 under rotation may not be distributed evenly over the surface of the substrate 1.

In these embodiments as well, the same effects as in the above-described embodiments may be obtained. Furthermore, in these embodiments, the moving average parameter can be set according to the rotational speed of the boat 31. Therefore, it is possible to perform accurate moving average processing. Therefore, even if fluctuations occur due to rotation, it is possible to perform highly accurate temperature control.

Further, the control parameter (e.g., the PID parameter) of the heater 40 may be set to correspond to the moving average parameter. When setting the control parameter according to the moving average parameter, for example, as shown in FIG. 14, a plurality of tables in which different control parameters are set for each moving average parameter may be prepared, and the table to be referenced may be switched according to the moving average parameter.

Also in this embodiment, the same effects as in the above-described embodiments may be obtained. Furthermore, in this embodiment, by associating the control parameter with the moving average parameter, it is possible to perform more accurate temperature control.

Furthermore, the control calculation may be performed by using the moving average value of the detected temperature values in the step in which the moving average parameter is set and by using the detected temperature values in the step in which the moving average parameter is not set. In this case, the control calculation may be performed by using the moving average value of the detected temperature values in the step in which the boat 31 is rotated and by using the detected temperature values in the step in which the boat 31 is not rotated.

In these embodiments as well, the same effects as in the above-described embodiments may be obtained. Furthermore, in these embodiments, even if fluctuations occur due to the rotation of the boat 31 and the rotation of the temperature sensor, the temperature fluctuations are suppressed because the moving average processing for the detected temperature values is performed.

Further, the temperature measurement portion of the temperature sensor (in the above-described embodiments, the temperature measurement portion 211b of the substrate thermocouple 211) may be arranged inside the peripheral portion of the substrate 1. In addition, the boat 31 may include holding member (in the above-described embodiments, the pillar 34) that holds the substrate 1, and the temperature measurement portion of the temperature sensor may be arranged in a vicinity of the holding member.

In these embodiments as well, the same effects as in the above-described embodiments may be obtained. Further, in these embodiments, the temperature sensor is further arranged in the space where the substrate 1 is processed. Therefore, it is possible to accurately measure the temperature of the substrate 1.

Furthermore, a plurality of temperature control regions may be provided, and the moving average parameter and the control parameter may be capable of being set for each temperature control region. Moreover, a plurality of temperature zone regions may be provided, and the moving average parameter and the control parameter may be capable of being set for each temperature zone region.

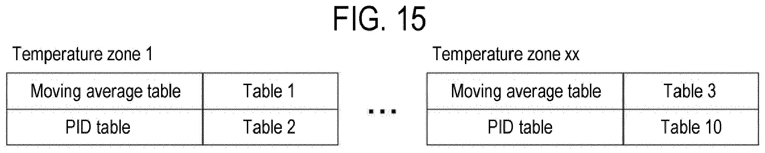

When setting the moving average parameter and the control parameter according to the temperature control region or the temperature zone region, for example, as shown in FIG. 15, a plurality of tables in which different moving average parameters and control parameters are set for each temperature control region or each temperature zone region may be prepared, and the table to be referenced may be switched depending on the temperature control region or the temperature zone region. Even with such an embodiment, the same effects as those of the above-described embodiments may be obtained.

Further, a configuration may be adopted in which the influence of fluctuations in the detected temperature values on the temperature control is suppressed. Also in this embodiment, the same effects as in the above-described embodiments may be obtained. Furthermore, in this embodiment, even if there is a fluctuation in the detected temperature values, the fluctuation is reflected little by little through the moving average processing. Therefore, it is possible to eliminate the occurrence of jumps in the output of the moving average processor and to perform a stable temperature control.

Further, the temperature value detected by the temperature sensor may be the same as the processing temperature set in the step of processing the substrate 1. In this case, the temperature value detected by the temperature sensor may be set to be equal to or lower than the standby temperature maintained when the substrate 1 is not arranged in the process tube 11.

Further, the processing temperature in this disclosure means the temperature of the substrate 1 or the temperature inside the process chamber 14.

In this way, a highly accurate temperature control can be performed even in a process in a low temperature range which is equal to or even lower than the standby temperature maintained when the substrate 1 are not arranged.

The above-described embodiments and modifications may be used in appropriate combinations. The processing procedure and processing conditions at this time may be, for example, similar to the processing procedure and processing conditions of the above-described embodiments and modifications. Further, unless otherwise specified in the specification, each element is not limited to one, and a plurality of elements may exist.

### <Other Embodiments>

The embodiments of the present disclosure have been specifically described above. However, the present disclosure is not limited to the above-described embodiments, and various changes can be made without departing from the gist thereof.

For example, in the above-described embodiments, there has been described the example in which a predetermined process is performed using the substrate processing apparatus which is a batch-type vertical apparatus that processes a plurality of substrates at a time. However, the present disclosure is not limited thereto. The present disclosure may also be suitably applied to a case where a film is formed using a single-substrate type substrate processing apparatus that processes one substrate at a time.

Further, the substrate processing apparatus according to the embodiment of the present disclosure is applicable not only to a semiconductor manufacturing apparatus for manufacturing semiconductors but also to an apparatus for processing glass substrates such as an LCD (Liquid Crystal Display) apparatus. Further, the substrate processing process includes, for example, a CVD process, a PVD process, a process for forming an oxide film or a nitride film, a process for forming a film containing metal, an annealing process, an oxidation process, a nitriding process, a diffusion process, and the like. The present disclosure can also be applied to various substrate processing apparatuses such as an exposure apparatus, a coating apparatus, a drying apparatus, and a heating apparatus.

According to the present disclosure in some embodiments, it is possible to suppress the influence of temperature fluctuations in a processing space on temperature control.

While certain embodiments have been described, these embodiments have been presented by way of example only, and are not intended to limit the scope of the disclosures. Indeed, the embodiments described herein may be embodied in a variety of other forms. Furthermore, various omissions, substitutions, and changes in the form of the embodiments described herein may be made without departing from the spirit of the disclosures. The accompanying claims and their equivalents are intended to cover such forms or modifications as would fall within the scope and spirit of the disclosures.

## Claims

1. A temperature control method, comprising:
controlling a temperature of a substrate by using a moving average value calculated by performing a moving average process on temperature values detected by a temperature sensor installed to be rotatable together with a holder configured to hold the substrate.

2. The temperature control method of Claim 1, wherein a process recipe including a plurality of steps is executable, and
wherein the moving average value is determined by a moving average parameter for each of the steps.

3. The temperature control method of Claim 2, wherein the moving average parameter is capable of being set according to a rotational speed of the holder that is arbitrarily set for each of the steps.

4. The temperature control method of Claim 2, wherein the moving average parameter is capable of being set according to rotational speed information including a predetermined rotational speed of the holder.

5. The temperature control method of Claim 2, wherein a control parameter of a heating part is set to correspond to the moving average parameter.

6. The temperature control method of Claim 2, wherein a control calculation is performed by using the moving average value of the detected temperature values in a step in which the moving average parameter is set and by using the detected temperature values in a step in which the moving average parameter is not set.

7. The temperature control method of Claim 6, wherein the control calculation is performed by using the moving average value of the detected temperature values in a step in which the holder is rotated and by using the detected temperature values in a step in which the holder is not rotated.

8. The temperature control method of Claim 1, wherein the temperature sensor includes a temperature measurement portion arranged inside a peripheral portion of the substrate.

9. The temperature control method of Claim 1, wherein the holder includes a holding member configured to hold the substrate, and
wherein the temperature sensor includes a temperature measurement portion arranged in a vicinity of the holding member.

10. The temperature control method of Claim 2, wherein the temperature values detected by the temperature sensor are set to be equal to a processing temperature set in a step of processing the substrate.

11. The temperature control method of Claim 10, wherein the temperature values detected by the temperature sensor are set to be equal to or lower than a standby temperature maintained in a state in which the substrate is not arranged in a reaction tube.

12. A method of manufacturing a semiconductor device, comprising:
controlling the temperature of the substrate to be set to a processing temperature by the temperature control method of Claim 1; and
processing the substrate while maintaining the processing temperature.

13. A temperature control system, comprising:
a temperature sensor installed to be rotatable together with a holder configured to hold a substrate;
a moving average processor configured to calculate a moving average value by performing a moving average process on temperature values detected by the temperature sensor; and
a controller configured to be capable of controlling a temperature of the substrate by using the moving average value of the detected temperature values.

14. A substrate processing apparatus, comprising a temperature control system including:
a temperature sensor installed to be rotatable together with a holder configured to hold a substrate;
a moving average processor configured to calculate a moving average value by performing a moving average process on temperature values detected by the temperature sensor; and
a controller configured to be capable of controlling a temperature of the substrate by using the moving average value of the detected temperature values.

15. A program that causes a computer to perform a process in a substrate processing apparatus including a temperature sensor installed to be rotatable together with a holder configured to hold a substrate, the process comprising:
calculating a moving average value by performing a moving average process on temperature values detected by the temperature sensor; and
controlling a temperature of the substrate by using the calculated moving average value.
